# EUROPEAN PATENT APPLICATION

(11) **EP 4 170 060 A1**
(43) Date of publication of application: **26.04.2023**
(21) Application number: 22808571.8
(22) Date of filing: 20.07.2022
(51) Int. Cl.: C23C 16/30, C23C 16/44, C23C 16/455, C23C 16/52

(54) **PREPARATION METHOD FOR SEMICONDUCTOR STRUCTURE, AND SEMICONDUCTOR GROWTH DEVICE**

(30) Priority: 09.09.2021 CN 202111053526
(71) Applicant: Suzhou Everbright Photonics Co., Ltd., Suzhou, Jiangsu 215011 (CN); Everbright Institute of Semiconductor Photonics Co., Ltd., Suzhou, Jiangsu 215011 (CN)
(72) Inventor: CHENG, Yang, Suzhou, Jiangsu 215011 (CN); WANG, Jun, Suzhou, Jiangsu 215011 (CN); XIAO, Xiao, Suzhou, Jiangsu 215011 (CN); GUO, Yingtao, Suzhou, Jiangsu 215011 (CN)
(74) Representative: Lavoix
(86) International application number: PCT/CN2022/106854
(87) International publication number: WO 2023/035784

(57) **Abstract**

The present application provides a method for a manufacturing semiconductor structure and a semiconductor growth device. The semiconductor growth device includes: a reaction chamber; a growth main pipe, where an end of the growth main pipe is connected to the reaction chamber; a vent main pipe; a first mixing main pipe to an M^{th} mixing main pipe, where M is an integer greater than or equal to 1; a first reaction gas source group to an N^{th} reaction gas source group, where N is an integer greater than or equal to 2; a first switching valve group to an N^{th} switching valve group, where a k^{th} switching valve group is adapted for controlling transport of gas from a k^{th} reaction gas source group to a j^{th} mixing main pipe, k is an integer greater than or equal to 1 and less than or equal to N, and j is an integer greater than or equal to 1 and less than or equal to M; and a first growth vent switching valve to an M^{th} growth vent switching valve, where a j^{th} growth vent switching valve is adapted for switching the gas in the j^{th} mixing main pipe to be transported to the growth main pipe or the vent main pipe. The use of the semiconductor growth device helps to improve the steepness of an interface in a growth process of a semiconductor structure.

## Description

This application claims priority to Chinese patent application No. 202111053526.2, entitled "METHOD FOR MANUFACTURING SEMICONDUCTOR STRUCTURE AND SEMICONDUCTOR GROWTH DEVICE", filed with the China National Intellectual Property Administration on September 9, 2021, the disclosure of which is hereby incorporated by reference in its entirety.

### TECHNICAL FIELD

The present application relates to the field of semiconductor technologies, and specifically to a method for a manufacturing semiconductor structure and a semiconductor growth device.

### BACKGROUND

Semiconductor lasers, photodetectors, high electron mobility transistors, and the like are important optoelectronic devices that have a broad market prospect in industrial and military fields. Epitaxial structures of these devices are mainly manufactured by metal organic chemical vapor deposition (MOCVD) or molecular beam epitaxy (MBE), and then epitaxial wafers are manufactured into qualified devices by a wafer process. The steepness of an epitaxial heterogeneous interface is one of the key indicators to characterize the quality of an epitaxial growth process, and the steepness of the heterogeneous interface has an important impact on device performance.

Compared with MBE, MOCVD has many advantages such as a large adjustable growth rate range, good equipment stability, and easy maintenance. Therefore, epitaxial structures of commercial devices are often grown by MOCVD. However, compared with MBE, the steepness of the heterogeneous interface grown by MOCVD is poor, affecting device performance to a certain extent.

### SUMMARY OF THE INVENTION

Therefore, a technical problem to be resolved by the present application is to overcome the problem that the steepness of a growth interface in the prior art is poor, and a method for a manufacturing semiconductor structure and a semiconductor growth device are provided.

The present application provides a semiconductor growth device, including: a reaction chamber; a growth main pipe, where an end of the growth main pipe is connected to the reaction chamber; a vent main pipe; a first mixing main pipe to an M^{th} mixing main pipe, where M is an integer greater than or equal to 1; a first reaction gas source group to an N^{th} reaction gas source group, where N is an integer greater than or equal to 2; a first switching valve group to an N^{th} switching valve group, where a k^{th} switching valve group is adapted for controlling transport of gas from a k^{th} reaction gas source group to a j^{th} mixing main pipe, k is an integer greater than or equal to 1 and less than or equal to N, and j is an integer greater than or equal to 1 and less than or equal to M; and a first growth vent switching valve to an M^{th} growth vent switching valve, where a j^{th} growth vent switching valve is adapted for switching the gas in the j^{th} mixing main pipe to be transported to the growth main pipe or the vent main pipe.

Optionally, M is equal to 1; and the k^{th} switching valve group is adapted for switching the gas in the k^{th} reaction gas source group to be transported to the first mixing main pipe or the vent main pipe.

Optionally, the device further includes: a first mixing branch pipe group to an N^{th} mixing branch pipe group, where the first mixing branch pipe group to the N^{th} mixing branch pipe group are all connected to the first mixing main pipe; a first gas source connection pipe group to an N^{th} gas source connection pipe group, where a k^{th} gas source connection pipe group is connected to the k^{th} reaction gas source group; and a first vent branch pipe group to an N^{th} vent branch pipe group, where the k^{th} switching valve group is adapted for switching gas in the k^{th} gas source connection pipe group to be transported to a k^{th} mixing branch pipe group or a k^{th} vent branch pipe group.

Optionally, the k^{th} mixing branch pipe group includes a first k^{th} sub-mixing branch pipe to a Qₖ^{th} k^{th} sub-mixing branch pipe; a k^{th} vent branch pipe group includes the first k^{th} sub-vent branch pipe to a Qk^{th} k^{th} sub-vent branch pipe; a k^{th} gas source connection pipe group includes the first k^{th} sub-gas source connection pipe to a Qk^{th} k^{th} sub-gas source connection pipe; and a k^{th} switching valve group includes the first k^{th} sub-switching valve to a Qk^{th} k^{th} sub-switching valve; and a qₖ^{th} k^{th} sub-switching valve is adapted for switching gas in a qₖ^{th} k^{th} sub-gas source connection pipe to be transported to a qₖ^{th} k^{th} sub-mixing branch pipe or a qₖ^{th} k^{th} sub-vent branch pipe, where qₖ is an integer greater than or equal to 1 and less than or equal to Qₖ.

Optionally, M is greater than or equal to 2, and M is less than or equal to N; and the k^{th} switching valve group is adapted for switching the gas in the k^{th} reaction gas source group to be transported to the j^{th} mixing main pipe or the vent main pipe.

Optionally, the device further includes: a first mixing branch pipe group to an N^{th} mixing branch pipe group, where a k^{th} mixing branch pipe group includes Qₖ^{∗}M k^{th} sub-mixing branch pipes, an (M^{∗}(qₖ-1)+1)^{th} k^{th} sub-mixing branch pipe to an (M^{∗}qₖ)^{th} k^{th} sub-mixing branch pipe are respectively correspondingly connected with the first mixing main pipe to the M^{th} mixing main pipe, and qₖ is an integer greater than or equal to 1 and less than or equal to Qₖ; a k^{th} vent branch pipe group includes a first k^{th} sub-vent branch pipe to a Qₖ^{th} k^{th} sub-vent branch pipe; and the k^{th} switching valve group includes a first k^{th} sub-switching valve to a Qₖ^{th} k^{th} sub-switching valve; and a qₖ^{th} k^{th} sub-switching valve is adapted for switching gas in a qₖ^{th} k^{th} sub-reaction gas source to be transported to any k^{th} sub-mixing branch pipe in the (M^{∗}(qₖ-1)+1)^{th} k^{th} sub-mixing branch pipe to the (M^{∗}qₖ)^{th} k^{th} sub-mixing branch pipe or transported to a qₖ^{th} k^{th} sub-vent branch pipe.

Optionally, the device further includes: a first gas source connection pipe group to an N^{th} gas source connection pipe group, where a k^{th} gas source connection pipe group includes a first k^{th} sub-gas source connection pipe to a Qₖ^{th} k^{th} sub-gas source connection pipe, and a qₖ^{th} k^{th} sub-gas source connection pipe is connected to the qₖ^{th} k^{th} sub-reaction gas source; and the qₖ^{th} k^{th} sub-switching valve is adapted for switching gas in the qₖ^{th} k^{th} sub-gas source connection pipe to be transported to any k^{th} sub-mixing branch pipe in the (M^{∗}(qₖ-1)+1)^{th} k^{th} sub-mixing branch pipe to the (M^{∗}qₖ)^{th} k^{th} sub-mixing branch pipe or transported to the qₖ^{th} k^{th} sub-vent branch pipe.

Optionally, the device further includes: a first growth connection pipe to an M^{th} growth connection pipe, where the first growth connection pipe to the M^{th} growth connection pipe are all connected to the growth main pipe; and a first vent connection pipe to an M^{th} vent connection pipe, where the first vent connection pipe to the M^{th} vent connection pipe are all connected to the vent main pipe, where the j^{th} growth vent switching valve is adapted for switching the gas in the j^{th} mixing main pipe to be transported to a j^{th} growth connection pipe or a j^{th} vent connection pipe.

Optionally, the semiconductor growth device includes a metal organic chemical vapor deposition device.

The present application further provides a method for a manufacturing semiconductor structure, using a semiconductor growth device in the present application, and including: controlling, by a k₁^{th} switching valve group, transport of gas from a k₁^{th} reaction gas source group to a j₁^{th} mixing main pipe, where the j₁^{th} mixing main pipe contains a k₁^{th} reaction mixed gas, and k₁ is an integer greater than or equal to 1 and less than or equal to N; switching, by a j₁^{th} growth vent switching valve, the k₁^{th} reaction mixed gas in the j₁^{th} mixing main pipe to be transported to a growth main pipe; after the switching, by a j₁^{th} growth vent switching valve, the k₁^{th} reaction mixed gas in the j₁^{th} mixing main pipe to be transported to a growth main pipe, switching all of first to M^{th} growth vent switching valves to be in communication with a vent main pipe to perform growth interruption in a reaction chamber; controlling, by a k₂^{th} switching valve group, transport of gas from a k₂^{th} reaction gas source group to a j₂^{th} mixing main pipe, where the j₂^{th} mixing main pipe contains a k₂^{th} reaction mixed gas, k₂ is an integer greater than or equal to 1 and less than or equal to N, k₂ is not equal to k₁, and j₂ is equal or not equal to ji; and after the growth interruption, switching, by a j₂^{th} growth vent switching valve, the k₂^{th} reaction mixed gas in the j₂^{th} mixing main pipe to be transported to the growth main pipe.

Optionally, M is equal to 1; the step of controlling, by a k₁^{th} switching valve group, transport of gas from a k₁^{th} reaction gas source group to a j₁^{th} mixing main pipe is: controlling, by the k₁^{th} switching valve group, transport of the gas from the k₁^{th} reaction gas source group to the first mixing main pipe; the step of switching, by a j₁^{th} growth vent switching valve, the k₁^{th} reaction mixed gas in the j₁^{th} mixing main pipe to be transported to a growth main pipe is: switching, by the first growth vent switching valve, the k₁^{th} reaction mixed gas in the first mixing main pipe to be transported to the growth main pipe; and during the growth interruption or after the growth interruption, controlling, by the k₂^{th} switching valve group, transport of the gas from the k₂^{th} reaction gas source group to the j₂^{th} mixing main pipe; the step of controlling, by a k₂^{th} switching valve group, transport of gas from a k₂^{th} reaction gas source group to a j₂^{th} mixing main pipe is: controlling, by the k₂^{th} switching valve group, transport of the gas from the k₂^{th} reaction gas source group to the first mixing main pipe; and the step of switching, by a j₂^{th} growth vent switching valve, the k₂^{th} reaction mixed gas in the j₂^{th} mixing main pipe to be transported to the growth main pipe is: switching, by the first growth vent switching valve, the k₂^{th} reaction mixed gas in the first mixing main pipe to be transported to the growth main pipe.

Optionally, M is greater than or equal to 2, and M is equal to N; and j₂ is not equal to j₁, k₁ is equal to j₁, and k₂ is equal to j₂.

Optionally, M is greater than or equal to 2, and M is less than N; the method further includes: before or after the controlling, by a k₁^{th} switching valve group, transport of gas from a k₁^{th} reaction gas source group to a j₁^{th} mixing main pipe, controlling, by a k₃^{th} switching valve group, transport of gas from a k₃^{th} reaction gas source group to a j₃^{th} mixing main pipe, where the j₃^{th} mixing main pipe contains a k₃^{th} reaction mixed gas; and switching, by a j₃^{th} growth vent switching valve, the k₃^{th} reaction mixed gas in the j₃^{th} mixing main pipe to be transported to the growth main pipe, where j₃ is equal to ji; or, before or after the controlling, by a k₂^{th} switching valve group, transport of gas from a k₂^{th} reaction gas source group to a j₂^{th} mixing main pipe, controlling, by a k₃^{th} switching valve group, transport of gas from a k₃^{th} reaction gas source group to a j₃^{th} mixing main pipe, where the j₃^{th} mixing main pipe contains a k₃^{th} reaction mixed gas; and switching, by a j₃^{th} growth vent switching valve, the k₃^{th} reaction mixed gas in the j₃^{th} mixing main pipe to be transported to the growth main pipe, where j₃ is equal to j₂, k₃ is an integer greater than or equal to 1 and less than or equal to N, and k₃ is not equal to k₁ and is not equal to k₂.

Optionally, a duration of the growth interruption ranges from 1 second to 10 seconds. The present application has the following beneficial effects.

In the method for a manufacturing semiconductor structure provided in the technical solutions of the present application, a k₁^{th} reaction mixed gas entering a reaction chamber reacts to form a k₁^{th} semiconductor film, and a k₂^{th} reaction mixed gas entering the reaction chamber reacts to form a k₂^{th} semiconductor film. Interruption processing is performed between the step of forming the k₁^{th} semiconductor film and the step of forming the k₂^{th} semiconductor film. The interruption helps to eliminate the retention of a residual source material after the reaction of the k₁^{th} reaction mixed gas on the k₁^{th} semiconductor film, to facilitate faster establishment of a stable concentration gradient of the k₂^{th} reaction mixed gas in the reaction chamber. Next, the interruption allows the k₁^{th} reaction mixed gas to be fully mixed in a j₁^{th} mixing main pipe before entering the reaction chamber. Therefore, gas in different k₁^{th} sub-reaction gas sources in a k₁^{th} reaction gas source group enters the reaction chamber at the same time. In summary, the steepness of an interface between the k₁^{th} semiconductor film and the k₂^{th} semiconductor film is improved.

### BRIEF DESCRIPTION OF THE DRAWINGS

To describe the technical solutions in specific embodiments of the present application or the prior art more clearly, the following briefly introduces the accompanying drawings required for describing the specific embodiments or the prior art. Apparently, the accompanying drawings in the following description show some embodiments of the present application, and a person of ordinary skill in the art may still derive other drawings from these accompanying drawings without creative efforts.
FIG. 1 is a switching status of source materials in a growth process of InGaAs/AlGaAs superlattices;
FIG. 2 is a schematic diagram of a gas pipe for generating AlGaAs;
FIG. 3 is a schematic diagram of a gas pipe at the instant of switching growth from AlGaAs to InGaAs;
FIG. 4 is a schematic structural diagram of a semiconductor growth device according to an embodiment of the present application;
FIG. 5 is a schematic structural diagram of a semiconductor growth device according to another embodiment of the present application; and

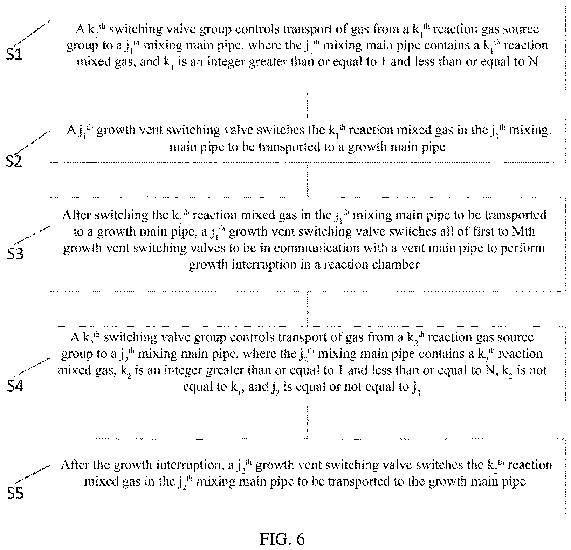

FIG. 6 is a flowchart of a process of manufacturing a semiconductor structure according to another embodiment of the present application.

### DETAILED DESCRIPTION

There are multiple reasons for the poor steepness of a heterogeneous interface grown by MOCVD, including the interdiffusion of components caused by a high growth temperature, the retention of a residual material at a boundary layer, inconsistent time of introducing source materials, inconsistent decomposition temperatures of source materials, and the like.

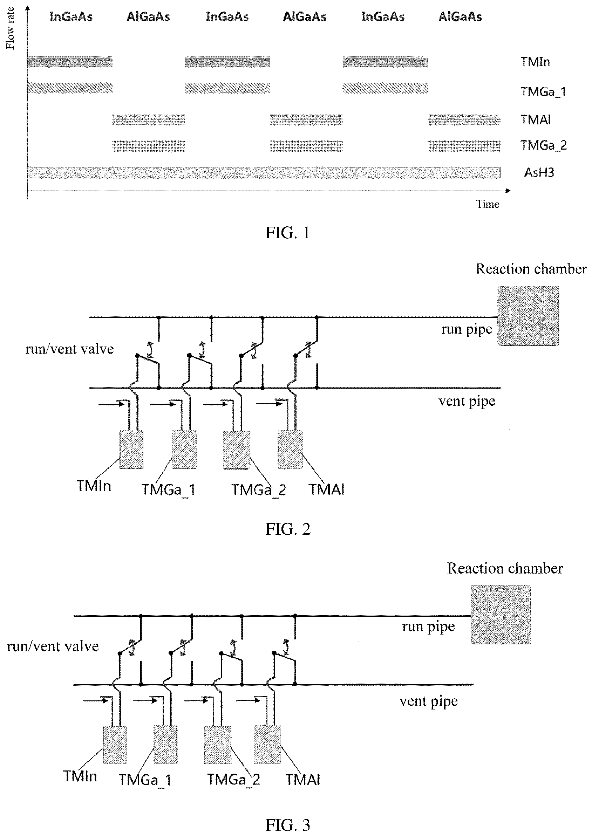

The growth of InGaAs/AlGaAs superlattices is used as an example. TMGa_1 (a first-way TMGa source) and trimethylindium (TMIn) are used as a group-III source for InGaAs, and trimethylaluminum (TMAl) and TMGa_2 (a second-way TMGa source) are used as a group-III source for AlGaAs, AsH3 is used as a group-V source for both, and the flow rate of AsH3 is kept constant in a growth process. FIG. 1 is a switching status of source materials in a growth process of InGaAs/AlGaAs superlattices. AsH3 keeps being introduced, the flow rate remains constant throughout the growth process. During the growth of InGaAs, TMIn and TMGa_1 are turned on, and TMA1 and TMGa_2 are turned off. During the growth of AlGaAs, TMA1 and TMGa_2 are turned on, and TMIn and TMGa_1 are turned off.

In an actual growth process, when the growth is switched from InGaAs to AlGaAs or from AlGaAs to InGaAs, there are interference of several factors, resulting in a non-steep InGaAs/AlGaAs heterogeneous interface.

One of the important factors is the asynchrony of the switching of the group-III sources. In an optimal case, the switching of the group-III sources needs to be synchronous. That is, the turning off of TMIn and TMGa_1 and the turning on of TMA1 and TMGa_2 should be simultaneous at the instant of switching a growth material from InGaAs to AlGaAs. In an actual case, there is a certain difference in the switching time of the run/vent valves that control the switching of the four source materials. That is, the four valves are not turned on or off at the same time. As a result, gas components in a run pipe are unstable at the instant of switching. In addition, the four run/vent valves cannot be at the same position on a gas pipe, and have different distances from a reaction chamber. As shown in FIG. 2, the run/vent valves of TMIn, TMGa_1, TMGa_2, and TMA1 are in descending order of distance from the reaction chamber. When the sources TMIn and TMGa_1 are turned off and TMA1 and TMGa_2 are turned on, the source materials of TMA1 and TMGa_2 enter the run pipe quickly, and the source materials of TMIn and TMGa_1 remain in the run pipe at this time. As a result, gas entering the reaction chamber contains four raw materials and have unstable components. Therefore, a heterogeneous interface grown at the instant of switching is not steep. FIG. 3 is a schematic diagram of a gas pipe at the instant of switching growth from AlGaAs to InGaAs. A time for which switching of the group-III sources is asynchronous usually ranges from 0.1 ms to 100 ms.

Another important factor is the retention effect of a source material on a growth surface. A source material in a gas flow in the reaction chamber is diffused to the growth surface using a concentration gradient, and it takes some time to establish a stable concentration gradient.

To increase the steepness of a heterogeneous interface, the present applicant has explored a method to increase the steepness of the heterogeneous interface after a painstaking search. The method can effectively suppress several factors that reduce the steepness of the interface, for example, inconsistent time of introducing source materials and the retention of a residual source material on a sample surface, thereby increasing the steepness of the heterogeneous interface.

An embodiment of the present application provides a semiconductor growth device, and growth interruption is combined, so that the asynchrony of switching of gas sources can be effectively eliminated, thereby improving the steepness of a heterogeneous interface.

The following clearly and completely describes the technical solutions in the present application with reference to the accompanying drawings. Apparently, the described embodiments are some rather than all of the embodiments of the present application. All other embodiments obtained by persons of ordinary skill in the art based on the embodiments of the present application without creative efforts shall fall within the protection scope of the present application.

In the description of the present application, it needs to be understood that orientation or location relationships indicated by terms "center", "up", "down", "left", "right", "vertical", "horizontal", "inside", and "outside" are based on orientation or location relationships shown in the accompanying drawings, and are only used to facilitate description of the present application and simplify description, but are not used to indicate or imply that the apparatuses or elements must have specific orientations or are constructed and operated by using specific orientations, and therefore, cannot be understood as a limit to the present application. In addition, the terms "first", "second", and "third" are used only for description, but are not intended to indicate or imply relative importance.

In the description of the present application, it needs to be noted that unless otherwise expressly specified and defined, "mounted", "connected", and "connection", should be understood in a broad sense, for example, fixedly connected, detachably connected or integrally connected; or mechanically connected or electrically connected; or connected directly or indirectly through an intermediate, or two elements communicated internally, or connected in a wireless manner, or connected in a wired manner. For a person of ordinary skill in the art, specific meanings of the terms in the present application should be understood according to specific conditions.

In addition, the technical features involved in different embodiments of the present application described below can be combined with each other as long as they do not constitute a conflict between them.

### Embodiment 1

An embodiment of the present application provides a semiconductor growth device, including:
a reaction chamber 100;
a growth main pipe 110, where an end of the growth main pipe 110 is connected to the reaction chamber 100;
a vent main pipe 120;
a first mixing main pipe to an M^{th} mixing main pipe, where M is an integer greater than or equal to 1;
a first reaction gas source group to an N^{th} reaction gas source group, where N is an integer greater than or equal to 2;
a first switching valve group to an N^{th} switching valve group, where a k^{th} switching valve group is adapted for controlling transport of gas from a k^{th} reaction gas source group to a j^{th} mixing main pipe, k is an integer greater than or equal to 1 and less than or equal to N, and j is an integer greater than or equal to 1 and less than or equal to M; and
a first growth vent switching valve to an M^{th} growth vent switching valve, where a j^{th} growth vent switching valve is adapted for switching the gas in the j^{th} mixing main pipe to be transported to the growth main pipe or the vent main pipe.

The k^{th} reaction gas source group includes a plurality of k^{th} sub-reaction gas sources. Specifically, the k^{th} reaction gas source group includes Qₖ k^{th} sub-reaction gas sources. The Qₖ k^{th} sub-reaction gas sources are respectively a first k^{th} sub-reaction gas source to a Qₖ^{th} k^{th} sub-reaction gas source. The Qₖ k^{th} sub-reaction gas sources have different gas. Qₖ is an integer greater than or equal to 2.

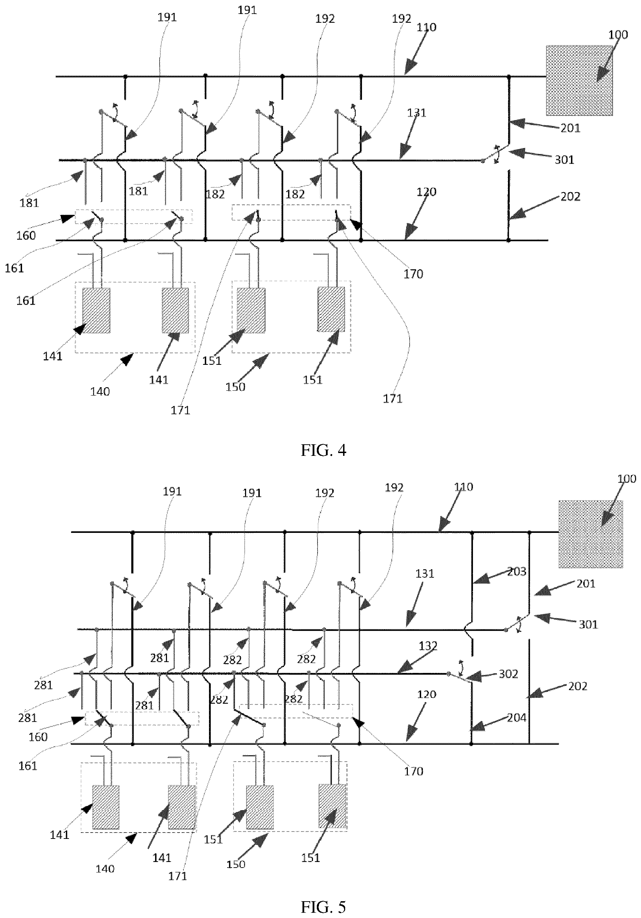

Referring to FIG. 4, N is equal to 2. The first reaction gas source group to the N^{th} reaction gas source group are respectively a first reaction gas source group 140 and a second reaction gas source group 150. The first reaction gas source group 140 includes two first-sub-reaction gas sources 141. Q1 is equal to 2. The two first-sub-reaction gas sources are respectively a first first-sub-reaction gas source and a second first-sub-reaction gas source. The second reaction gas source group 150 includes two second-sub-reaction gas sources 151. Q2 is equal to 2. The two second-sub-reaction gas sources are respectively a first second-sub-reaction gas source and a second second-sub-reaction gas source.

In a specific embodiment, the k^{th} reaction gas source group includes two k^{th} sub-reaction gas sources. The first reaction gas source group 140 includes two first-sub-reaction gas sources. The two first-sub-reaction gas sources have different gas. For example, one of the two first-sub-reaction gas sources is a first sub-Ga gas source, and the other is a first sub-indium gas source. The second reaction gas source group 150 includes two second-sub-reaction gas sources. The two second-sub-reaction gas sources have different gas. For example, one of the two second-sub-reaction gas sources is a second sub-Ga gas source, and the other is a second sub-Al gas source.

It needs to be noted that the k^{th} reaction gas source group may include more than two k^{th} sub-reaction gas sources. A quantity of k₁^{th} sub-reaction gas sources is equal to or not equal to a quantity of k₂^{th} sub-reaction gas sources, and k₂ is not equal to k₁. k₁ is an integer greater than or equal to 1 and less than or equal to N, and k₂ is an integer greater than or equal to 1 and less than or equal to N.

In the first switching valve group to the N^{th} switching valve group, the k^{th} switching valve group includes Qₖ k^{th} sub-switching valves. The Qₖ k^{th} sub-switching valves are respectively a first k^{th} sub-switching valve to a Qₖ^{th} k^{th} sub-switching valve. A quantity of k^{th} sub-switching valves in the k^{th} switching valve group is equal to a quantity of k^{th} sub-reaction gas sources in the k^{th} reaction gas source group. One k^{th} sub-switching valve corresponds to one k^{th} sub-reaction gas source.

Referring to FIG. 4, N is equal to 2, and the device includes a first switching valve group 160 and a second switching valve group 170. The first switching valve group 160 includes two first-sub-switching valves 161. The two first-sub-switching valves are respectively a first first-sub-switching valve and a second first-sub-switching valve. The second switching valve group 170 includes two second-sub-switching valves 171. The two second-sub-switching valves are respectively a first second-sub-switching valve and a second second-sub-switching valve.

Referring to FIG. 4, M is equal to 1. A mixing main pipe only includes a first mixing main pipe 131.

The first mixing main pipe 131 can select the k^{th} reaction gas source group through the k^{th} switching valve group to introduce a gas. When it is selected to introduce gas in a k₁^{th} reaction gas source group into the first mixing main pipe, gas in a k₂^{th} reaction gas source group is not introduced into the first mixing main pipe, where k₂ is not equal to k₁, k₁ is an integer greater than or equal to 1 and less than or equal to N, and k₂ is an integer greater than or equal to 1 and less than or equal to N. When N is equal to 2 and gas in the first reaction gas source group 140 is introduced into the first mixing main pipe 131, gas in the second reaction gas source group 150 is not introduced into the first mixing main pipe 131. When gas in the second reaction gas source group 150 is introduced into the first mixing main pipe 131, gas in the first reaction gas source group 140 is not introduced into the first mixing main pipe 131.

Referring to FIG. 4, the k^{th} switching valve group is adapted for switching the gas in the k^{th} reaction gas source group to be transported to the first mixing main pipe 131 or the vent main pipe 120. The first switching valve group 160 is adapted for switching the gas in the first reaction gas source group 140 to be transported to the first mixing main pipe 131 or the vent main pipe 120. The second switching valve group 170 is adapted for switching the gas in the second reaction gas source group 150 to be transported to the first mixing main pipe 131 or the vent main pipe 120.

The semiconductor growth device further includes: a first mixing branch pipe group to an N^{th} mixing branch pipe group, where the first mixing branch pipe group to the N^{th} mixing branch pipe group are all connected to the first mixing main pipe 131; a k^{th} mixing branch pipe group includes a plurality of k^{th} sub-mixing branch pipes, where specifically, the k^{th} mixing branch pipe group includes Qₖ k^{th} sub-mixing branch pipes, and the Qₖ k^{th} sub-mixing branch pipes are respectively a first k^{th} sub-mixing branch pipe to a Qₖ^{th} k^{th} sub-mixing branch pipe; a first vent branch pipe group to an N^{th} vent branch pipe group, where a k^{th} vent branch pipe group includes Qₖ k^{th} sub-vent branch pipes, the k^{th} sub-vent branch pipes are connected to the vent main pipe 120, and the Qₖ k^{th} sub-vent branch pipes are respectively a first k^{th} sub-vent branch pipe to a Qₖ^{th} k^{th} sub-vent branch pipe, where the k^{th} switching valve group is adapted for switching gas in the k^{th} gas source connection pipe group to be transported to a k^{th} mixing branch pipe group or a k^{th} vent branch pipe group; and a qₖ^{th} k^{th} sub-switching valve is adapted for switching gas in a qₖ^{th} k^{th} sub-reaction gas source to be transported to a qₖ^{th} k^{th} sub-mixing branch pipe or a qₖ^{th} k^{th} sub-vent branch pipe. qₖ is an integer greater than or equal to 1 and less than or equal to Qₖ.

The semiconductor growth device further includes: a first gas source connection pipe group to an N^{th} gas source connection pipe group, where the k^{th} gas source connection pipe group is connected to the k^{th} reaction gas source group; specifically, the k^{th} gas source connection pipe group includes Qₖ k^{th} sub-gas source connection pipes, the Qₖ k^{th} sub-gas source connection pipes are respectively a first k^{th} sub-gas source connection pipe to a Qₖ^{th} k^{th} sub-gas source connection pipe, and a qₖ^{th} k^{th} sub-switching valve is adapted for switching gas in a qₖ^{th} k^{th} sub-gas source connection pipe to be transported to a qₖ^{th} k^{th} sub-mixing branch pipe or a qₖ^{th} k^{th} sub-vent branch pipe.

Referring to FIG. 4, the semiconductor growth device includes: a first mixing branch pipe group and a second mixing branch pipe group, where the first mixing branch pipe group includes two first-sub-mixing branch pipes 181, the second mixing branch pipe group includes two second-sub-mixing branch pipes 182, and the first-sub-mixing branch pipes 181 and the second-sub-mixing branch pipes 182 are both connected to the first mixing main pipe 131; and a first vent branch pipe group to a second vent branch pipe group, where the first vent branch pipe group includes two first-sub-vent branch pipes 191, the second vent branch pipe group includes two second-sub-vent branch pipes 192, and the first-sub-vent branch pipes 191 and the second-sub-vent branch pipes 192 are both connected to the vent main pipe 120, where the first-sub-switching valve 161 is adapted for switching the gas in the first reaction gas source group 141 to be transported to the first mixing main pipe 181 or the first-sub-vent branch pipe 191, the second-sub-switching valve 171 is adapted for switching the gas in the second reaction gas source group 151 to be transported to the second mixing main pipe 182 or the second-sub-vent branch pipe 192, specifically, one first-sub-switching valve 161 is adapted for switching the gas in one first reaction gas source group 141 to be transported to one first mixing main pipe 181 or one first-sub-vent branch pipe 191, and one second-sub-switching valve 171 is adapted for switching the gas in one second reaction gas source group 151 to be transported to one second mixing main pipe 182 or one second-sub-vent branch pipe 192.

The semiconductor growth device further includes: a first growth connection pipe to an M^{th} growth connection pipe, where the first growth connection pipe to the M^{th} growth connection pipe are all connected to the growth main pipe 110; and a first vent connection pipe to an M^{th} vent connection pipe, where the first vent connection pipe to the M^{th} vent connection pipe are all connected to the vent main pipe 120. The j^{th} growth vent switching valve is adapted for switching the gas in the j^{th} mixing main pipe to be transported to a j^{th} growth connection pipe or a j^{th} vent connection pipe.

Referring to FIG. 4, M is equal to 1, and correspondingly, the semiconductor growth device includes: a first growth vent switching valve 301; and the semiconductor growth device further includes: a first growth connection pipe 201; and a first vent connection pipe 202, where the first growth vent switching valve 301 is adapted for switching the gas in the first mixing main pipe 131 to be transported to the first growth connection pipe 201 or the first vent connection pipe 202.

It needs to be noted that the gas in the first mixing main pipe 131 is transported from the k^{th} sub-mixing branch pipe to the first growth vent switching valve.

The semiconductor growth device further includes: a first growth branch pipe group to an N^{th} growth branch pipe group connected to the growth main pipe 110, where a k^{th} growth branch pipe group includes Qₖ k^{th} sub-growth branch pipes (not shown); a first additional vent branch pipe group to an N^{th} additional vent branch pipe group, where a k^{th} additional vent branch pipe group includes Qₖ k^{th} sub-additional vent branch pipes; and a first additional switching valve group to an N^{th} additional switching valve group, where a k^{th} additional switching valve group includes Qₖ k^{th} sub-additional switching valves, a qₖ^{th} k^{th} sub-switching valve is adapted for switching gas in a qₖ^{th} k^{th} sub-reaction gas source to be transported to a qₖ^{th} k^{th} sub-mixing branch pipe or a qₖ^{th} k^{th} sub-additional vent branch pipe, and the qₖ^{th} k^{th} sub-additional vent branch pipe transports gas to the qₖ^{th} k^{th} sub-vent branch pipe or a qₖ^{th} k^{th} sub-growth branch pipe through a qₖ^{th} k^{th} sub-additional switching valve.

The growth main pipe 110 has a first end and a second end opposite to each other in an extension direction of the growth main pipe 110, the first end is connected to the reaction chamber 100, and the second end is sealed. When the first growth branch pipe group to the N^{th} growth branch pipe group are provided, connections between the first growth branch pipe group to the N^{th} growth branch pipe group and the growth main pipe 110 are all arranged between the first end and the second end.

The semiconductor growth device includes a metal organic chemical vapor deposition device.

### Embodiment 2

Differences between this embodiment and the previous embodiment lie in that: M is greater than or equal to 2, and M is less than or equal to N; and the k^{th} switching valve group is adapted for switching the gas in the k^{th} reaction gas source group to be transported to the j^{th} mixing main pipe or the vent main pipe.

The k^{th} reaction gas source group includes a plurality of k^{th} sub-reaction gas sources. Specifically, the k^{th} reaction gas source group includes Qₖ k^{th} sub-reaction gas sources. The Qₖ k^{th} sub-reaction gas sources are respectively a first k^{th} sub-reaction gas source to a Qₖ^{th} k^{th} sub-reaction gas source. The Qₖ k^{th} sub-reaction gas sources have different gas. Qₖ is an integer greater than or equal to 2. The plurality of k^{th} sub-reaction gas sources have different gas.

The k^{th} switching valve group includes a plurality of k^{th} sub-switching valves. Specifically, the k^{th} switching valve group includes Qₖ k^{th} sub-switching valves. The Qₖ k^{th} sub-switching valves are respectively a first k^{th} sub-switching valve to a Qₖ^{th} k^{th} sub-switching valve. A quantity of k^{th} sub-switching valves in the k^{th} switching valve group is equal to a quantity of k^{th} sub-reaction gas sources in the k^{th} reaction gas source group. One k^{th} sub-switching valve corresponds to one k^{th} sub-reaction gas source.

In this embodiment, the semiconductor growth device further includes: a first mixing branch pipe group to an N^{th} mixing branch pipe group, where a k^{th} mixing branch pipe group includes a plurality of k^{th} sub-mixing branch pipes, and any j^{th} mixing main pipe in a first mixing main pipe to an M^{th} mixing main pipe is connected to some k^{th} sub-mixing branch pipes in the plurality of k^{th} sub-mixing branch pipes. Specifically, the k^{th} mixing branch pipe group includes Qₖ^{∗}M k^{th} sub-mixing branch pipes; the j^{th} mixing main pipe is connected to Qₖ k^{th} sub-mixing branch pipes; and a k^{th} vent branch pipe group includes Qₖ k^{th} sub-vent branch pipes. An (M^{∗}(qₖ-1)+1)^{th} k^{th} sub-mixing branch pipe to an (M^{∗}qₖ)^{th} k^{th} sub-mixing branch pipe are respectively correspondingly connected to the first mixing main pipe to the M^{th} mixing main pipe. Any two k^{th} sub-mixing branch pipes in the (M^{∗}(qₖ-1)+1)^{th} k^{th} sub-mixing branch pipe to the (M^{∗}qₖ)^{th} k^{th} sub-mixing branch pipe are connected to different mixing main pipes. qₖ is an integer greater than or equal to 1 and less than or equal to Qₖ; the k^{th} vent branch pipe group includes the first k^{th} sub-vent branch pipe to the Qₖ^{th} k^{th} sub-vent branch pipe; and the k^{th} switching valve group includes the first k^{th} sub-switching valve to the Qₖ^{th} k^{th} sub-switching valve. A qₖ^{th} k^{th} sub-switching valve is adapted for switching gas in a qₖ^{th} k^{th} sub-reaction gas source to be transported to any k^{th} sub-mixing branch pipe in the (M^{∗}(qₖ-1)+1)^{th} k^{th} sub-mixing branch pipe to the (M^{∗}qₖ)^{th} k^{th} sub-mixing branch pipe or transported to a qₖ^{th} k^{th} sub-vent branch pipe.

That the (M^{∗}(qₖ-1)+1)^{th} k^{th} sub-mixing branch pipe to the (M^{∗}qₖ)^{th} k^{th} sub-mixing branch pipe are respectively correspondingly connected to the first mixing main pipe to the M^{th} mixing main pipe refers to that the (M^{∗}(qₖ-1)+1)^{th} k^{th} sub-mixing branch pipe is connected to the first mixing main pipe, an (M^{∗}(qₖ-1)+2)^{th} k^{th} sub-mixing branch pipe is connected to a second mixing main pipe, the (M^{∗}qₖ)^{th} k^{th} sub-mixing branch pipe is connected to the M^{th} mixing main pipe, and the like.

The semiconductor growth device further includes: a first gas source connection pipe group to an N^{th} gas source connection pipe group, where the k^{th} gas source connection pipe group includes Qₖ k^{th} sub-gas source connection pipes, the Qₖ k^{th} sub-gas source connection pipes are respectively a first k^{th} sub-gas source connection pipe to a Qₖ^{th} k^{th} sub-gas source connection pipe, and a qₖ^{th} k^{th} sub-gas source connection pipe is connected to the qₖ^{th} k^{th} sub-reaction gas source. The qₖ^{th} k^{th} sub-switching valve is adapted for switching gas in the qₖ^{th} k^{th} sub-gas source connection pipe to be transported to any k^{th} sub-mixing branch pipe in the (M^{∗}(qₖ-1)+1)^{th} k^{th} sub-mixing branch pipe to the (M^{∗}qₖ)^{th} k^{th} sub-mixing branch pipe or transported to the qₖ^{th} k^{th} sub-vent branch pipe.

Referring to FIG. 5, M is greater than or equal to 2, and M is equal to N. The semiconductor growth device includes: a reaction chamber 100; a growth main pipe 110; a vent main pipe 120; a first reaction gas source group 140 and a second reaction gas source group 150, where the first reaction gas source group 140 includes two first-sub-reaction gas sources 141, Q1 is equal to 2, the two first-sub-reaction gas sources are respectively a first first-sub-reaction gas source and a second first-sub-reaction gas source, the second reaction gas source group 150 includes two second-sub-reaction gas sources 151, Q2 is equal to 2, and the two second-sub-reaction gas sources are respectively a first second-sub-reaction gas source and a second second-sub-reaction gas source; a first switching valve group 160 and a second switching valve group 170, where the first switching valve group 160 includes two first-sub-switching valves 161, the two first-sub-switching valves are respectively a first first-sub-switching valve and a second first-sub-switching valve, the second switching valve group 170 includes two second-sub-switching valves 171, and the two second-sub-switching valves are respectively a first second-sub-switching valve and a second second-sub-switching valve; a first mixing branch pipe group and a second mixing branch pipe group, where the first mixing branch pipe group includes four first-sub-mixing branch pipes 281, the four first-sub-mixing branch pipes are respectively a first first-sub-mixing branch pipe, a second first-sub-mixing branch pipe, a third first-sub-mixing branch pipe, and a fourth first-sub-mixing branch pipe, the first first-sub-mixing branch pipe and the second first-sub-mixing branch pipe are respectively correspondingly connected to the first mixing main pipe and the second mixing main pipe, and the third first-sub-mixing branch pipe and the fourth first-sub-mixing branch pipe are respectively correspondingly connected to the first mixing main pipe and the second mixing main pipe, where the second mixing branch pipe group includes four second-sub-mixing branch pipes 282, the four second-sub-mixing branch pipes are respectively a first second-sub-mixing branch pipe, a second second-sub-mixing branch pipe, a third second-sub-mixing branch pipe, and a fourth second-sub-mixing branch pipe, the first second-sub-mixing branch pipe and the second second-sub-mixing branch pipe are respectively correspondingly connected to the first mixing main pipe and the second mixing main pipe, and the third second-sub-mixing branch pipe and the fourth second-sub-mixing branch pipe are respectively correspondingly connected to the first mixing main pipe and the second mixing main pipe; and a first vent branch pipe group and a second vent branch pipe group, where the first vent branch pipe group includes two first-sub-vent branch pipes 191, the two first-sub-vent branch pipes are respectively a first first-sub-vent branch pipe and a second first-sub-vent branch pipe, the second vent branch pipe group includes two second-sub-vent branch pipes 192, the two second-sub-vent branch pipes are respectively a first second-sub-vent branch pipe and a second second-sub-vent branch pipe, and the first-sub-vent branch pipes 191 and the second-sub-vent branch pipes 192 are both connected to the vent main pipe 120, where the first first-sub-switching valve is adapted for switching the gas in the first first-sub-reaction gas source to be transported to the first first-sub-mixing branch pipe, the second first-sub-mixing branch pipe or the first first-sub-vent branch pipe, where the second first-sub-switching valve is adapted for switching the gas in the second first-sub-reaction gas source to be transported to the third first-sub-mixing branch pipe, the fourth first-sub-mixing branch pipe or the second first-sub-vent branch pipe; the first second-sub-switching valve is adapted for switching the gas in the first second-sub-reaction gas source to be transported to the first second-sub-mixing branch pipe, the second second-sub-mixing branch pipe or the first second-sub-vent branch pipe; and the second second-sub-switching valve is adapted for switching the gas in the second second-sub-reaction gas source to be transported to the third second-sub-mixing branch pipe, the fourth second-sub-mixing branch pipe or the second second-sub-vent branch pipe.

Referring to FIG. 5, the semiconductor growth device further includes: a first gas source connection pipe group and a second gas source connection pipe group, where the first gas source connection pipe group includes two first-sub-gas source connection pipes, and the two first-sub-gas source connection pipes are respectively a first first-sub-gas source connection pipe and a second first-sub-gas source connection pipe; the first first-sub-gas source connection pipe is connected to the first first-sub-reaction gas source, and the second first-sub-gas source connection pipe is connected to the second first-sub-reaction gas source; the second gas source connection pipe group includes two second-sub-gas source connection pipes, and the two second-sub-gas source connection pipes are respectively a first second-sub-gas source connection pipe and a second second-sub-gas source connection pipe; and the first second-sub-gas source connection pipe is connected to the first second-sub-reaction gas source, and the second second-sub-gas source connection pipe is connected to the second second-sub-reaction gas source. The first first-sub-switching valve is adapted for switching the gas in the first first-sub-gas source connection pipe to be transported to the first first-sub-mixing branch pipe, the second first-sub-mixing branch pipe or the first first-sub-vent branch pipe; the second first-sub-switching valve is adapted for switching the gas in the second first-sub-gas source connection pipe to be transported to the third first-sub-mixing branch pipe, the fourth first-sub-mixing branch pipe or the second first-sub-vent branch pipe; the first second-sub-switching valve is adapted for switching the gas in the first second-sub-gas source connection pipe to be transported to the first second-sub-mixing branch pipe, the second second-sub-mixing branch pipe or the first second-sub-vent branch pipe; the second second-sub-switching valve is adapted for switching the gas in the second second-sub-gas source connection pipe to be transported to the third second-sub-mixing branch pipe, the fourth second-sub-mixing branch pipe or the second second-sub-vent branch pipe.

The semiconductor growth device further includes: a first growth connection pipe to an M^{th} growth connection pipe, where the first growth connection pipe to the M^{th} growth connection pipe are all connected to the growth main pipe; and a first vent connection pipe to an M^{th} vent connection pipe, where the first vent connection pipe to the M^{th} vent connection pipe are all connected to the vent main pipe. The j^{th} growth vent switching valve is adapted for switching the gas in the j^{th} mixing main pipe to be transported to a j^{th} growth connection pipe or a j^{th} vent connection pipe.

Referring to FIG. 5, M is equal to 2, and the semiconductor growth device includes: a first growth connection pipe 201 and a second growth connection pipe 203; a first vent connection pipe 202 and a second vent connection pipe 204; and a first growth vent switching valve 301 and a second growth vent switching valve 302, where the j^{th} growth vent switching valve is adapted for switching the gas in the j^{th} mixing main pipe to be transported to a j^{th} growth connection pipe or a j^{th} vent connection pipe; the first growth vent switching valve 301 is adapted for switching the gas in the first mixing main pipe 131 to be transported to the first growth connection pipe 201 or the first vent connection pipe 202; and the second growth vent switching valve 302 is adapted for switching the gas in the second mixing main pipe 132 to be transported to the second growth connection pipe 203 or the second vent connection pipe 204.

The semiconductor growth device further includes: a first growth branch pipe group to an N^{th} growth branch pipe group connected to the growth main pipe 110, where a k^{th} growth branch pipe group includes Qₖ k^{th} sub-growth branch pipes (not shown); a first additional vent branch pipe group to an N^{th} additional vent branch pipe group, where a k^{th} additional vent branch pipe group includes Qₖ k^{th} sub-additional vent branch pipes; and a first additional switching valve group to an N^{th} additional switching valve group, where a k^{th} additional switching valve group includes Qₖ k^{th} sub-additional switching valves, a qₖ^{th} k^{th} sub-switching valve is adapted for switching gas in a qₖ^{th} k^{th} sub-reaction gas source to be transported to any k^{th} sub-mixing branch pipe in the (M^{∗}(qₖ-1)+1)^{th} k^{th} sub-mixing branch pipe to the (M^{∗}qₖ)^{th} k^{th} sub-mixing branch pipe or transported to a qₖ^{th} k^{th} sub-additional vent branch pipe, where the qₖ^{th} k^{th} sub-additional vent branch pipe transports gas to the qₖ^{th} k^{th} sub-vent branch pipe or a qₖ^{th} k^{th} sub-growth branch pipe through a qₖ^{th} k^{th} sub-additional switching valve.

For the same content in this embodiment and the previous embodiment, details are not described again.

It needs to be noted that Embodiment 1 and Embodiment 2 above further include a common gas source. The common gas source is adapted for being introduced into the growth main pipe 110. Before, during, and after the growth interruption, the common gas source is introduced continuously. For example, the common gas source includes AsH₃.

### Embodiment 3

This embodiment provides a method for a manufacturing semiconductor structure, using the foregoing semiconductor growth device, and including the following steps.

Step S1: A k₁^{th} switching valve group controls transport of gas from a k₁^{th} reaction gas source group to a j₁^{th} mixing main pipe, where the j₁^{th} mixing main pipe contains a k₁^{th} reaction mixed gas, and k₁ is an integer greater than or equal to 1 and less than or equal to N.

Step S2: A j₁^{th} growth vent switching valve switches the k₁^{th} reaction mixed gas in the j₁^{th} mixing main pipe to be transported to a growth main pipe.

Step S3: After switching the k₁^{th} reaction mixed gas in the j₁^{th} mixing main pipe to be transported to a growth main pipe, the j₁^{th} growth vent switching valve switches all of first to M^{th} growth vent switching valves to be in communication with a vent main pipe to perform growth interruption in a reaction chamber.

Step S4: A k₂^{th} switching valve group controls transport of gas from a k₂^{th} reaction gas source group to a j₂^{th} mixing main pipe, where the j₂^{th} mixing main pipe contains a k₂^{th} reaction mixed gas, k₂ is an integer greater than or equal to 1 and less than or equal to N, k₂ is not equal to k₁, and j₂ is equal or not equal to j₁.

Step S5: After the growth interruption, a j₂^{th} growth vent switching valve switches the k₂^{th} reaction mixed gas in the j₂^{th} mixing main pipe to be transported to the growth main pipe.

When M is equal to 1, the step of controlling, by a k₁^{th} switching valve group, transport of gas from a k₁^{th} reaction gas source group to a j₁^{th} mixing main pipe is: controlling, by the k₁^{th} switching valve group, transport of the gas from the k₁^{th} reaction gas source group to the first mixing main pipe; the step of switching, by a j₁^{th} growth vent switching valve, the k₁^{th} reaction mixed gas in the j₁^{th} mixing main pipe to be transported to a growth main pipe is: switching, by the first growth vent switching valve, the k₁^{th} reaction mixed gas in the first mixing main pipe to be transported to the growth main pipe; and during the growth interruption or after the growth interruption, controlling, by the k₂^{th} switching valve group, transport of the gas from the k₂^{th} reaction gas source group to the j₂^{th} mixing main pipe; the step of controlling, by a k₂^{th} switching valve group, transport of gas from a k₂^{th} reaction gas source group to a j₂^{th} mixing main pipe is: controlling, by the k₂^{th} switching valve group, transport of the gas from the k₂^{th} reaction gas source group to the first mixing main pipe; and the step of switching, by a j₂^{th} growth vent switching valve, the k₂^{th} reaction mixed gas in the j₂^{th} mixing main pipe to be transported to the growth main pipe is: switching, by the first growth vent switching valve, the k₂^{th} reaction mixed gas in the first mixing main pipe to be transported to the growth main pipe.

The semiconductor growth device in FIG. 4 is used as an example for description. The first switching valve group controls transport of the gas from the first reaction gas source group to the first mixing main pipe, and a q₁^{th} first-sub-switching valve controls transport of the gas from a q₁^{th} first-sub-reaction gas source to a q₁^{th} first-sub-mixing branch pipe, to allow the first mixing main pipe to have a first reaction mixed gas. The first growth vent switching valve switches the first reaction mixed gas in the first mixing main pipe to be transported to the growth main pipe. Specifically, the first growth vent switching valve switches the first reaction mixed gas in the first mixing main pipe to be transported to the first growth connection pipe. After switching the first reaction mixed gas in the first mixing main pipe to be transported to the growth main pipe, the first growth vent switching valve is switched to be in communication with the vent main pipe to perform growth interruption in the reaction chamber. Specifically, the first growth vent switching valve is switched to be in communication with the first vent connection pipe to perform growth interruption in the reaction chamber. During the growth interruption or after the growth interruption, the second switching valve group controls transport of the gas from the second reaction gas source group to the first mixing main pipe. Specifically, a q₂^{th} second-sub-switching valve controls transport of the gas from a q₂^{th} second-sub-reaction gas source to a q₂^{th} second-sub-mixing branch pipe, to allow the second mixing main pipe to have a second reaction mixed gas. After the interruption, the first growth vent switching valve switches the second reaction mixed gas in the first mixing main pipe to be transported to the first growth connection pipe.

When M is greater than or equal to 2 and M is equal to N, j₂ is not equal to j₁, k₁ is equal to j₁, and k₂ is equal to j₂.

In other embodiments, optionally, M is greater than or equal to 2, and M is less than N. In this case, any j^{th} mixing main pipe can be selected for gas in a qₖ^{th} k^{th} sub-reaction gas source for mixing and transporting gas. In this case, the method further includes: before or after the controlling, by a k₁^{th} switching valve group, transport of gas from a k₁^{th} reaction gas source group to a j₁^{th} mixing main pipe, controlling, by a k₃^{th} switching valve group, transport of gas from a k₃^{th} reaction gas source group to a j₃^{th} mixing main pipe, where the j₃^{th} mixing main pipe contains a k₃^{th} reaction mixed gas; and switching, by a j₃^{th} growth vent switching valve, the k₃^{th} reaction mixed gas in the j₃^{th} mixing main pipe to be transported to the growth main pipe, and growth interruption is also set between the step of switching, by a j₃^{th} growth vent switching valve, the k₃^{th} reaction mixed gas in the j₃^{th} mixing main pipe to be transported to the growth main pipe and the step of switching, by a j₁^{th} growth vent switching valve, the k₁^{th} reaction mixed gas in the j₁^{th} mixing main pipe to be transported to a growth main pipe; and j₃ is equal to j₁. In another embodiment, the method further includes: before or after the controlling, by a k₂^{th} switching valve group, transport of gas from a k₂^{th} reaction gas source group to a j₂^{th} mixing main pipe, controlling, by a k₃^{th} switching valve group, transport of gas from a k₃^{th} reaction gas source group to a j₃^{th} mixing main pipe, where the j₃^{th} mixing main pipe contains a k₃^{th} reaction mixed gas; and switching, by a j₃^{th} growth vent switching valve, the k₃^{th} reaction mixed gas in the j₃^{th} mixing main pipe to be transported to the growth main pipe, and growth interruption is also set between the step of switching, by a j₃^{th} growth vent switching valve, the k₃^{th} reaction mixed gas in the j₃^{th} mixing main pipe to be transported to the growth main pipe and the step of switching, by a j₂^{th} growth vent switching valve, the k₂^{th} reaction mixed gas in the j₂^{th} mixing main pipe to be transported to a growth main pipe; and j₃ is equal to j₂.

k₃ is an integer greater than or equal to 1 and less than or equal to N, and k₃ is not equal to k₁ and is not equal to k₂.

A duration of the growth interruption ranges from 1 second to 10 seconds.

It needs to be noted that in a process of performing step 1 to step 5, the common gas source is introduced continuously into the growth main pipe 110.

A k₁^{th} reaction mixed gas entering a reaction chamber reacts to form a k₁^{th} semiconductor film, and a k₂^{th} reaction mixed gas entering the reaction chamber reacts to form a k₂^{th} semiconductor film. Interruption processing is performed between the step of forming the k₁^{th} semiconductor film and the step of forming the k₂^{th} semiconductor film. The interruption processing helps to eliminate the retention of a residual source material after the reaction of the k₁^{th} reaction mixed gas on the k₁^{th} semiconductor film, to facilitate faster establishment of a stable concentration gradient of the k₂^{th} reaction mixed gas in the reaction chamber. Next, the interruption processing allows the k₁^{th} reaction mixed gas to be fully mixed in a j₁^{th} mixing main pipe before entering the reaction chamber. Therefore, gas in different k₁^{th} sub-reaction gas sources in a k₁^{th} reaction gas source group enters the reaction chamber at the same time. In summary, the steepness of an interface between the k₁^{th} semiconductor film and the k₂^{th} semiconductor film is improved.

A growth rate of an epitaxial layer is reduced and a growth interruption is increased, so that a gas pause time can be reduced, thereby helping to establish a stable concentration gradient more quickly.

Obviously, the foregoing embodiments are merely examples for clear description, rather than a limitation to implementations. For a person of ordinary skill in the art, other changes or variations in different forms may also be made based on the foregoing description. All implementations cannot and do not need to be exhaustively listed herein. Obvious changes or variations that are derived there from still fall within the protection scope of present application.

## Claims

1. A semiconductor growth device, comprising:
a reaction chamber;
a growth main pipe, where an end of the growth main pipe is connected to the reaction chamber;
a vent main pipe;
a first mixing main pipe to an M^{th} mixing main pipe, where M is an integer greater than or equal to 1;
a first reaction gas source group to an N^{th} reaction gas source group, where N is an integer greater than or equal to 2;
a first switching valve group to an N^{th} switching valve group, where a k^{th} switching valve group is adapted for controlling transport of gas from a k^{th} reaction gas source group to a j^{th} mixing main pipe, k is an integer greater than or equal to 1 and less than or equal to N, and j is an integer greater than or equal to 1 and less than or equal to M; and
a first growth vent switching valve to an M^{th} growth vent switching valve, where a j^{th} growth vent switching valve is adapted for switching the gas in the j^{th} mixing main pipe to be transported to the growth main pipe or the vent main pipe.

2. The semiconductor growth device according to claim 1, where M is equal to 1; and the k^{th} switching valve group is adapted for switching the gas in the k^{th} reaction gas source group to be transported to the first mixing main pipe or the vent main pipe.

3. The semiconductor growth device according to claim 2, further including: a first mixing branch pipe group to an N^{th} mixing branch pipe group, where the first mixing branch pipe group to the N^{th} mixing branch pipe group are all connected to the first mixing main pipe; a first gas source connection pipe group to an N^{th} gas source connection pipe group, where a k^{th} gas source connection pipe group is connected to the k^{th} reaction gas source group; and a first vent branch pipe group to an N^{th} vent branch pipe group, where the k^{th} switching valve group is adapted for switching gas in the k^{th} gas source connection pipe group to be transported to a k^{th} mixing branch pipe group or a k^{th} vent branch pipe group.

4. The semiconductor growth device according to claim 3, where the k^{th} mixing branch pipe group includes a first k^{th} sub-mixing branch pipe to a Qₖ^{th} k^{th} sub-mixing branch pipe; a k^{th} vent branch pipe group includes the first k^{th} sub-vent branch pipe to a Qₖ^{th} k^{th} sub-vent branch pipe; a k^{th} gas source connection pipe group includes the first k^{th} sub-gas source connection pipe to a Qₖ^{th} k^{th} sub-gas source connection pipe; and a k^{th} switching valve group includes the first k^{th} sub-switching valve to a Qk^{th} k^{th} sub-switching valve; and
a qₖ^{th} k^{th} sub-switching valve is adapted for switching gas in a qₖ^{th} k^{th} sub-gas source connection pipe to be transported to a qₖ^{th} k^{th} sub-mixing branch pipe or a qₖ^{th} k^{th} sub-vent branch pipe, where qₖ is an integer greater than or equal to 1 and less than or equal to Qₖ.

5. The semiconductor growth device according to claim 1, where M is greater than or equal to 2, and M is less than or equal to N; and the k^{th} switching valve group is adapted for switching the gas in the k^{th} reaction gas source group to be transported to the j^{th} mixing main pipe or the vent main pipe.

6. The semiconductor growth device according to claim 5, further including: a first mixing branch pipe group to an N^{th} mixing branch pipe group, where a k^{th} mixing branch pipe group includes Qₖ^{∗}M k^{th} sub-mixing branch pipes, an (M^{∗}(qₖ-1)+1)^{th} k^{th} sub-mixing branch pipe to an (M^{∗}qₖ)^{th} k^{th} sub-mixing branch pipe are respectively correspondingly connected with the first mixing main pipe to the M^{th} mixing main pipe, and qₖ is an integer greater than or equal to 1 and less than or equal to Qₖ; a k^{th} vent branch pipe group includes a first k^{th} sub-vent branch pipe to a Qₖ^{th} k^{th} sub-vent branch pipe; and the k^{th} switching valve group includes a first k^{th} sub-switching valve to a Qₖ^{th} k^{th} sub-switching valve; and
a qₖ^{th} k^{th} sub-switching valve is adapted for switching gas in a qₖ^{th} k^{th} sub-reaction gas source to be transported to any k^{th} sub-mixing branch pipe in the (M^{∗}(qₖ-1)+1)^{th} k^{th} sub-mixing branch pipe to the (M^{∗}qₖ)^{th} k^{th} sub-mixing branch pipe or transported to a qₖ^{th} k^{th} sub-vent branch pipe.

7. The semiconductor growth device according to claim 6, further including: a first gas source connection pipe group to an N^{th} gas source connection pipe group, where a k^{th} gas source connection pipe group includes a first k^{th} sub-gas source connection pipe to a Qₖ^{th} k^{th} sub-gas source connection pipe, and a qₖ^{th} k^{th} sub-gas source connection pipe is connected to the qₖ^{th} k^{th} sub-reaction gas source; and
the qₖ^{th} k^{th} sub-switching valve is adapted for switching gas in the qₖ^{th} k^{th} sub-gas source connection pipe to be transported to any k^{th} sub-mixing branch pipe in the (M^{∗}(qₖ-1)+1)^{th} k^{th} sub-mixing branch pipe to the (M^{∗}qₖ)^{th} k^{th} sub-mixing branch pipe or transported to the qₖ^{th} k^{th} sub-vent branch pipe.

8. The semiconductor growth device according to any one of claims 1 to 7, further including: a first growth connection pipe to an M^{th} growth connection pipe, where the first growth connection pipe to the M^{th} growth connection pipe are all connected to the growth main pipe; and a first vent connection pipe to an M^{th} vent connection pipe, where the first vent connection pipe to the M^{th} vent connection pipe are all connected to the vent main pipe, where
the j^{th} growth vent switching valve is adapted for switching the gas in the j^{th} mixing main pipe to be transported to a j^{th} growth connection pipe or a j^{th} vent connection pipe.

9. The semiconductor growth device according to claim 1, where the semiconductor growth device includes a metal organic chemical vapor deposition device.

10. A method for manufacturing a semiconductor structure, using the semiconductor growth device according to any one of claims 1 to 9, and including:
controlling, by a k₁^{th} switching valve group, transport of gas from a k₁^{th} reaction gas source group to a j₁^{th} mixing main pipe, where the j₁^{th} mixing main pipe contains a k₁^{th} reaction mixed gas, and k₁ is an integer greater than or equal to 1 and less than or equal to N;
switching, by a j₁^{th} growth vent switching valve, the k₁^{th} reaction mixed gas in the j₁^{th} mixing main pipe to be transported to a growth main pipe;
after the switching, by a j₁^{th} growth vent switching valve, the k₁^{th} reaction mixed gas in the j₁^{th} mixing main pipe to be transported to a growth main pipe, switching all of first to M^{th} growth vent switching valves to be in communication with a vent main pipe to perform growth interruption in a reaction chamber;
controlling, by a k₂^{th} switching valve group, transport of gas from a k₂^{th} reaction gas source group to a j₂^{th} mixing main pipe, where the j₂^{th} mixing main pipe contains a k₂^{th} reaction mixed gas, k₂ is an integer greater than or equal to 1 and less than or equal to N, k₂ is not equal to k₁, and j₂ is equal or not equal to j₁; and
after the growth interruption, switching, by a j₂^{th} growth vent switching valve, the k₂^{th} reaction mixed gas in the j₂^{th} mixing main pipe to be transported to the growth main pipe.

11. The method for manufacturing a semiconductor structure according to claim 10, where M is equal to 1; and the step of controlling, by a k₁^{th} switching valve group, transport of gas from a k₁^{th} reaction gas source group to a j₁^{th} mixing main pipe is: controlling, by the k₁^{th} switching valve group, transport of the gas from the k₁^{th} reaction gas source group to the first mixing main pipe;
the step of switching, by a j₁^{th} growth vent switching valve, the k₁^{th} reaction mixed gas in the j₁^{th} mixing main pipe to be transported to a growth main pipe is: switching, by the first growth vent switching valve, the k₁^{th} reaction mixed gas in the first mixing main pipe to be transported to the growth main pipe; and
during the growth interruption or after the growth interruption, controlling, by the k₂^{th} switching valve group, transport of the gas from the k₂^{th} reaction gas source group to the j₂^{th} mixing main pipe;
the step of controlling, by a k₂^{th} switching valve group, transport of gas from a k₂^{th} reaction gas source group to a j₂^{th} mixing main pipe is: controlling, by the k₂^{th} switching valve group, transport of the gas from the k₂^{th} reaction gas source group to the first mixing main pipe; and
the step of switching, by a j₂^{th} growth vent switching valve, the k₂^{th} reaction mixed gas in the j₂^{th} mixing main pipe to be transported to the growth main pipe is: switching, by the first growth vent switching valve, the k₂^{th} reaction mixed gas in the first mixing main pipe to be transported to the growth main pipe.

12. The method for manufacturing a semiconductor structure according to claim 10, where M is greater than or equal to 2, and M is equal to N; and j₂ is not equal to j₁, k₁ is equal to j₁, and k₂ is equal to j₂.

13. The method for manufacturing a semiconductor structure according to claim 10, where M is greater than or equal to 2, and M is less than N; and
the method further includes: before or after the controlling, by a k₁^{th} switching valve group, transport of gas from a k₁^{th} reaction gas source group to a j₁^{th} mixing main pipe, controlling, by a k₃^{th} switching valve group, transport of gas from a k₃^{th} reaction gas source group to a j₃^{th} mixing main pipe, where the j₃^{th} mixing main pipe contains a k₃^{th} reaction mixed gas; and switching, by a j₃^{th} growth vent switching valve, the k₃^{th} reaction mixed gas in the j₃^{th} mixing main pipe to be transported to the growth main pipe, where j₃ is equal to ji;
or, before or after the controlling, by a k₂^{th} switching valve group, transport of gas from a k₂^{th} reaction gas source group to a j₂^{th} mixing main pipe, controlling, by a k₃^{th} switching valve group, transport of gas from a k₃^{th} reaction gas source group to a j₃^{th} mixing main pipe, where the j₃^{th} mixing main pipe contains a k₃^{th} reaction mixed gas; and switching, by a j₃^{th} growth vent switching valve, the k₃^{th} reaction mixed gas in the j₃^{th} mixing main pipe to be transported to the growth main pipe, where j₃ is equal to j₂,
k₃ is an integer greater than or equal to 1 and less than or equal to N, and k₃ is not equal to k₁ and is not equal to k₂.

14. The method for manufacturing a semiconductor structure according to claim 10, where a duration of the growth interruption ranges from 1 second to 10 seconds.
